# EUROPEAN PATENT APPLICATION

(11) **EP 2 503 694 A2**
(43) Date of publication of application: **26.09.2012**
(21) Application number: 12159797.5
(22) Date of filing: 16.03.2012
(51) Int. Cl.: H03K 17/567, H03K 17/74, H03K 17/16

(54) **III-nitride transistor with passive oscillation prevention**

(30) Priority: 21.03.2011 US 201161454743 P; 14.03.2012 US 201213419820
(71) Applicant: International Rectifier Corporation, El Segundo, CA 90245 (US)
(72) Inventor: Briere, Michael A., Scottsdale, AZ Arizona 85266 (US); Thapar, Naresh, San Diego, CA California 92130 (US)
(74) Representative: Dr. Weitzel & Partner

(57) **Abstract**

There are disclosed herein various implementations of semiconductor devices having passive oscillation control. In one exemplary implementation, such a device (400) is implemented to include a III-nitride transistor (410) having a source electrode (402), a gate electrode (408) and a drain electrode (404). A damping resistor (470) is configured to provide the passive oscillation control for the III-nitride transistor. In one implementation, the damping resistor includes at least one lumped resistor.

## Description

### BACKGROUND

The present application claims the benefit of and priority to a pending provisional application entitled "III-Nitride Optimized Rugged Cascode Power Device," Serial No. 61/454,743 filed on March 21, 2011. The disclosure in this pending provisional application is hereby incorporated fully by reference into the present application.

### I. DEFINITIONS

As used herein, the phrase "III-Nitride" or " III-N" refers to a compound semiconductor that includes nitrogen and at least one group III element including aluminum (Al), gallium (Ga), indium (In), and boron (B), and including but not limited to any of its alloys, such as aluminum gallium nitride (AlₓGa₍₁₋ₓ₎N), indium gallium nitride (InyGa_{(1-y)}N), aluminum indium gallium nitride (AlₓOnyGa_{(1-x-y})N), gallium arsenide phosphide nitride (GaAsₐP_{b}N_{(1-a-b)}), aluminum indium gallium arsenide phosphide nitride (AlₓInyGa_{(1-x-y)}AsₐP_{b}N_{(1-a-b)}), for example. III-Nitride also refers generally to any polarity including but not limited to Ga-polar, N-polar, semi-polar or non-polar crystal orientations. A III-Nitride material may also include either the Wurtzitic, Zincblende or mixed polytypes, and may include single-crystal, monocrystalline, polycrystalline, or amorphous structures.

Also, as used herein, the terms "LV-device," "low voltage semiconductor device," "low voltage transistor," and the like, refer to a low voltage device, with a typical voltage range of up to approximately 50 volts. Typical voltage ratings include low voltage (LV) ∼ 0-50V, midvoltage (MV) ∼ 50-200V, high voltage (HV) ∼ 200-1200V and ultra high voltage (UHV) ∼ >1200V. The device can comprise any suitable semiconductor material that forms a field-effect transistor (FET) or diode, or a combination of a FET and a diode. Suitable semiconductor materials include group IV semiconductor materials such as silicon, strained silicon, SiGe, SiC, and group III-V materials including III-As, III-P, III-Nitride or any of their alloys.

### II. BACKGROUND ART

111-Nitride materials are semiconductor compounds that have relatively wide direct bandgaps and can have strong piezoelectric polarizations, and which can enable high breakdown fields, high saturation velocities, and the creation of two-dimensional electron gases (2DEGs). As a result, III-Nitride materials are used in many power applications such as depletion mode (e.g., normally ON) power field-effect transistors (power FETs), high electron mobility transistors (HEMTs), and diodes.

In certain power management applications where normally OFF characteristics of power devices are desirable, a depletion mode III-Nitride power transistor can be cascoded with a low voltage (LV) semiconductor device to produce an enhancement mode composite power device. However, the utility and durability of such a composite device can be limited according to characteristics of the III-Nitride power transistor and LV semiconductor device being used in combination. For example, when implemented with an LV semiconductor device to form a composite device used in high current applications, or otherwise operating during high slew rate conditions, the gate of the III-Nitride power transistor may tend to oscillate in series with semiconductor package inductances and the output capacitance of the LV semiconductor device, for example, causing the III-Nitride power transistor to be undesirably turned OFF and ON. Unless controlled and dampened, such oscillations may adversely affect the functionality and utility of the composite semiconductor device, and can also be destructive and reduce the durability of the composite semiconductor device.

Similarly, in certain other power management applications where a III-Nitride based HEMT is used to drive an inductive load, detrimental parasitics may cause ringing to occur within the circuit when the HEMT is switched at very fast rates, which can also be destructive and reduce the durability of the III-Nitride device.

### SUMMARY

The present disclosure is directed to a III-nitride transistor with passive oscillation prevention, substantially as shown in and/or described in connection with at least one of the figures, and as set forth more completely in the claims.

### BRIEF DESCRIPTION OF THE DRAWINGS

Figure 1 presents a diagram showing an example of a conventional implementation of a III-Nitride device.
Figure 2 presents a diagram showing one exemplary implementation of a III-nitride transistor.
Figure 3 shows an exemplary implementation for providing passive oscillation control for a III-nitride transistor.
Figure 4 shows an exemplary implementation for providing passive oscillation control for a composite semiconductor device.
Figure 5 shows another exemplary implementation for providing passive oscillation control for a composite semiconductor device.
Figure 6 shows yet another exemplary implementation for providing passive oscillation control for a composite semiconductor device.

### DETAILED DESCRIPTION

The following description contains specific information pertaining to implementations in the present disclosure. One skilled in the art will recognize that the present disclosure may be implemented in a manner different from that specifically discussed herein. The drawings in the present application and their accompanying detailed description are directed to merely exemplary implementations. Unless noted otherwise, like or corresponding elements among the figures may be indicated by like or corresponding reference numerals. Moreover, the drawings and illustrations in the present application are generally not to scale, and are not intended to correspond to actual relative dimensions.

III-Nitride materials include, for example, gallium nitride (GaN) and its alloys such as aluminum gallium nitride (AlGaN), indium gallium nitride (InGaN), and aluminum indium gallium nitride (AlInGaN). These materials are semiconductor compounds that have a relatively wide direct bandgap, can have strong piezoelectric polarizations, and can enable high breakdown fields, high saturation velocities, and the creation of two-dimensional electron gases (2DEGs). As a result, and as noted above, III-Nitride materials such as GaN are used in many microelectronic applications as depletion mode (e.g., normally ON) power field-effect transistors (power FETs), high electron mobility transistors (HEMTs), and diodes.

As further noted above, in power management applications where normally OFF characteristics of power devices are desirable, a depletion mode III-Nitride power transistor can be cascoded with a low voltage (LV) semiconductor device to produce an enhancement mode composite power device. However, the utility and durability of such a composite device can be limited according to characteristics of the III-Nitride power transistor and LV semiconductor device being cascoded together. For example, when implemented in combination with an LV semiconductor device to form a composite device used in high current applications, the gate of the III-Nitride power transistor may tend to oscillate in series with semiconductor package inductances and the output capacitance of the LV semiconductor device, for example, causing the III-Nitride power transistor to be turned OFF and ON. Unless controlled, such oscillation can be destructive, and may undesirably reduce the durability of the composite semiconductor device. Thus, in order to render such composite devices suitable for operation in power management systems, where high slew rate conditions may be encountered, the III-Nitride device should be configured so as to be oscillation resistant.

The present application is directed to a III-nitride transistor having passive oscillation control. According to one implementation, the III-nitride transistor may be a III-Nitride power transistor, such as a III-nitride field-effect transistor (III-N FET) or a III-nitride high electron mobility transistor (III-N HEMT), which may be a normally ON device, for example, and may be configured with other semiconductor devices to form a composite semiconductor device acting as a switch or a rectifier, for example. As disclosed herein, a gate electrode of such a III-Nitride power transistor may include damping resistor configured to provide passive oscillation control for the III-Nitride device. The III-nitride transistor may also be cascoded with an LV device, such as a silicon or other group IV FET, for example. The cascoded combination of the LV device and the normally ON III-Nitride power transistor can be implemented to produce a normally OFF composite semiconductor device. As further disclosed herein, the composite semiconductor device may be configured such that the LV device drives the gate of the normally ON III-Nitride power transistor through a damping resistor configured to provide passive oscillation control for the normally OFF composite semiconductor device.

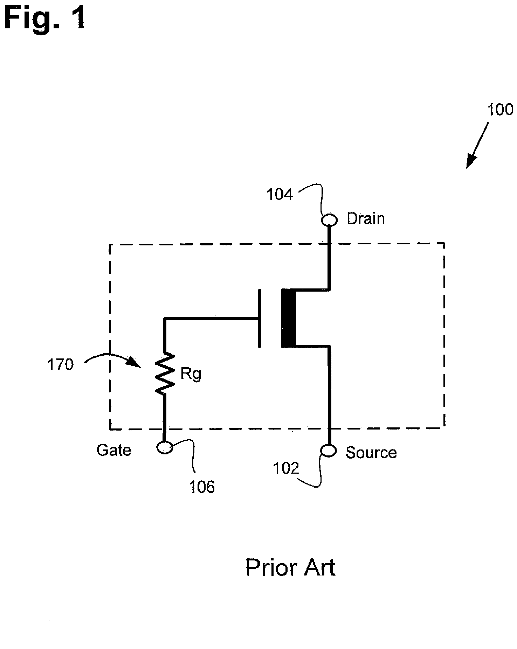

Referring to Figure 1, conventional **III**-nitride transistor 100 is schematically represented. III-nitride transistor 100, which may be a III-N HEMT, for example, is shown to include source electrode 102, drain electrode 104 and gate electrode 106. Also shown in Figure 1 is distributed gate resistance 170 associated with gate electrode 106.

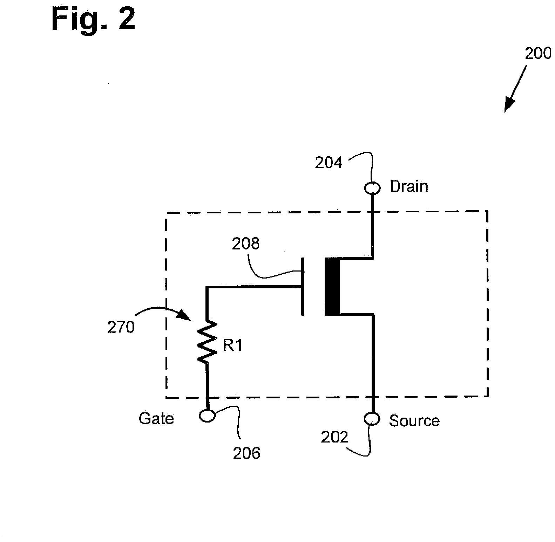

Referring to Figure 2, an exemplary implementation of a III-nitride transistor according to the present inventive concepts is shown. III-nitride transistor 200, which may be a III-N FET or III-N HEMT, for example, is shown to include source electrode 202, drain electrode 204 and gate electrode 206. According to the present implementation, distributed gate resistance 170 of conventional III-Nitride HEMT 100, in Figure 1, has been replaced with gate electrode 206 designed to provide a different specific distributed gate resistance as damping resistor 270. Moreover, III-nitride transistor 200 may be implemented as a transistor configured to have passive oscillation control by forming gate electrode 206 such that it includes damping resistor 270 implemented as distributed resistor R1. Alternatively, passive oscillation control may be effectuated through optimization of damping resistor 270. For example, in those applications where III-nitride transistor 200 is designed for high current operation, it may be preferable to have damping resistor 270 assume higher values, such as approximately 2-5 ohms, for example, in order to prevent oscillations by gate 208 of III-nitride transistor 200. In one implementation, those higher values of damping resistor 270 can be realized as a distributed resistance in the design and layout of **III**-Nitride power transistor 200. Moreover, in some implementations, damping resistor 270 may be produced through use of narrow metal lines for the interconnect to gate 208 of III-nitride transistor 200, or through use of higher resistance metallic materials, such as tantalum nitride (TaN) or titanium nitride (TiN), for instance, instead of the commonly utilized aluminum (Al).

In other implementations, as will be discussed further below, it may be advantageous to form gate electrode 206 such that gate electrode 206 does not provide a damping distributed resistance. For example, when gate electrode 206 includes a distributed resistor and a lumped resistor, the lumped resistor may provide the damping resistance for oscillation control, but the distributed resistor may be formed of a lower resistance material as may be needed in a composite semiconductor device configuration. That is to say, in some implementations, damping resistor 270 may include at least one lumped resistor formed of a high resistance metallic material, and may further include a distributed resistor formed of a lower resistance metallic material.

As noted above, III-nitride transistor 200 may be a III-Nitride heterostructure FET (III-N HFET), for example. In one implementation, III-nitride transistor 200 may take the form of a metal-insulator-semiconductor FET (MISFET or MISHFET), such as a metal-oxide-semiconductor FET (MOSFET). Alternatively, when implemented as an HFET, III-nitride transistor 200 may be a HEMT configured to produce a 2DEG. According to one implementation, for example, III-nitride transistor 200 may be a high voltage (HV) device configured to sustain a drain voltage of approximately 600V and having a gate rating of approximately 40V.

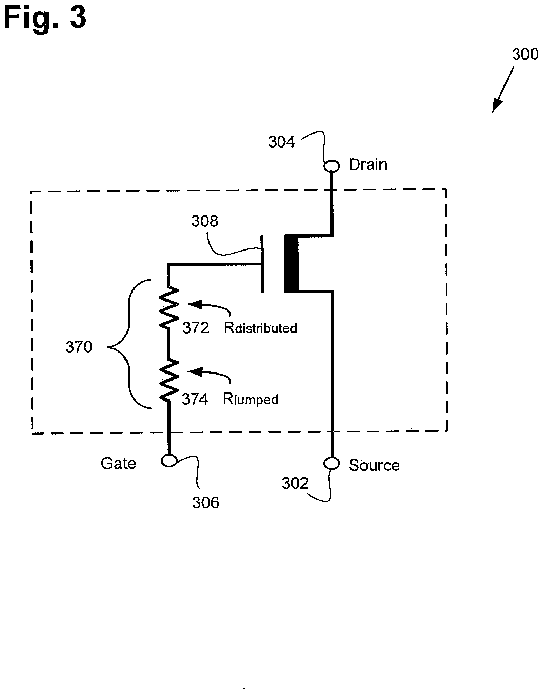

Figure 3 shows an example implementation utilizing a lumped gate resistor in combination with a distributed gate resistor to provide passive oscillation control. As shown in Figure 3, III-nitride transistor 300 includes source electrode 302, drain electrode 304, gate electrode 306, and gate 308. Gate 308 is driven through damping resistor 370, which is represented as including lumped resistor 374 and distributed resistor 372. III-nitride transistor 300 corresponds to III-nitride transistor 200, in Figure 2, and may share any of the features previously attributed to that corresponding device, above.

According to the implementation shown in Figure 3, damping resistor 370 is shown to be the sum of distributed resistor 372 and lumped resistor 374. As noted above, distributed resistor 372 may be a product of the device layout. Moreover, the thickness and type of the gate metals utilized in III-nitride transistor 300 can be optimized in order to achieve a desired value for this distributed portion of damping resistor 370. In high current applications, an additional external lumped resistor my be implemented as lumped resistor 374 in order to increase damping resistor 370 and further enhance passive oscillation control, so as to enable stable high slew rate operation.

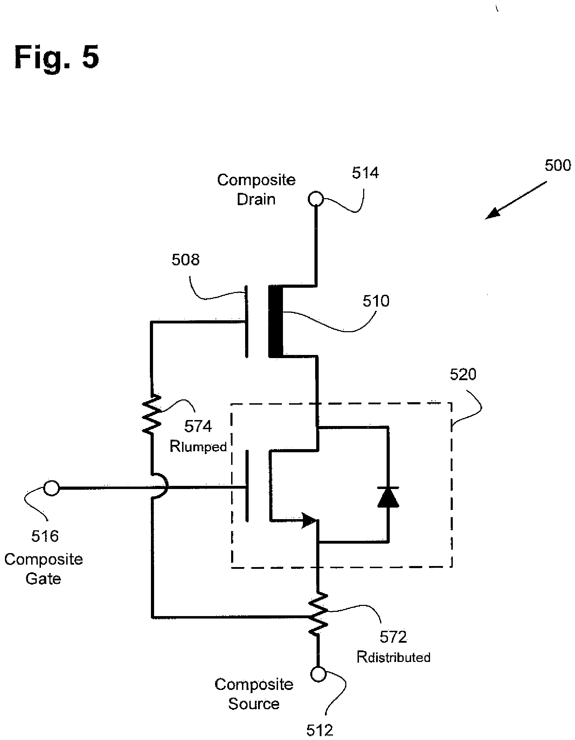

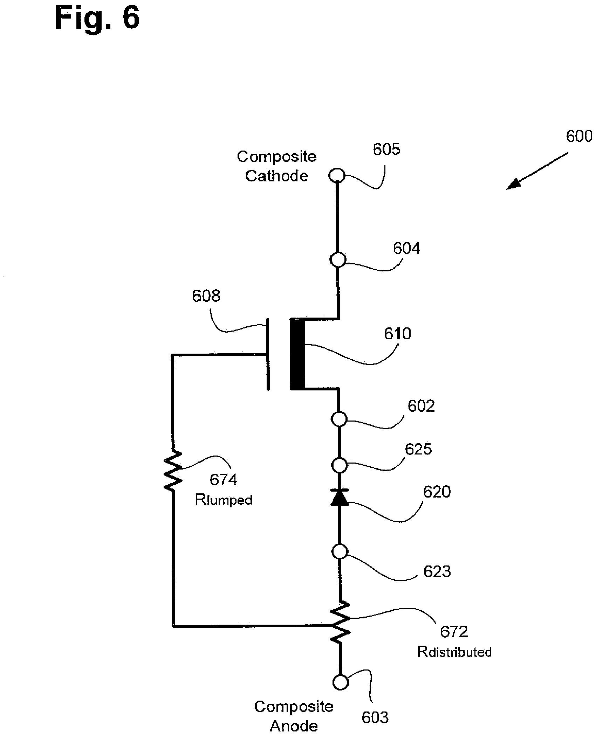

Alternatively, and as will be discussed further below, it may be advantageous to form gate electrode 306 of III-nitride transistor 300 such that gate electrode 306 does not provide a damping distributed resistance. Instead, damping resistance 370 may utilize lumped resistor 374 to provide the damping resistance relied upon for oscillation control. This may be the case when distributed resistor 372 is formed of a low resistance material, as may be required for the composite semiconductor device configurations discussed below in conjunction with Figures 5 and 6.

Continuing to refer to Figure 3, lumped resistor 374 may be implemented as a discrete resistor in series with distributed resistor 372. However, it may be advantageous to form lumped resistor 374 monolithically within III-Nitride device 300. In such a monolithic implementation, lumped resistor 374 may be formed in a metal layer within the metallization layers of III-nitride transistor 300 other than a metallization layer used to form gate 308 and/or distributed resistor 372 (metallization layers not shown in Figure 3). Lumped Resistor 374 may be formed of a metal with a higher resistance (e.g., AlTi) which is electrically connected in series with gate 308 and distributed resistor 372, which may be formed of a lower resistance material (e.g., Al or copper (Cu)) using another metallization layer of III-nitride transistor 300.

It is noted that, although the implementation shown in Figure 3 depicts a single lumped resistor 374, in other implementations, more than one lumped resistor may be utilized to produce damping resistor 370. Thus, damping resistor 370 may be understood to correspond generally to at least one lumped resistor.

In is also noted that in implementations where III-nitride transistor 300 is formed on a foreign substrate (e.g., a non-III-Nitride substrate) such as a silicon or silicon carbide (SiC) substrate, for example, lumped resistor 374 may be monolithically integrated within the substrate itself (substrate not shown in Figure 3), or within the III-Nitride material.

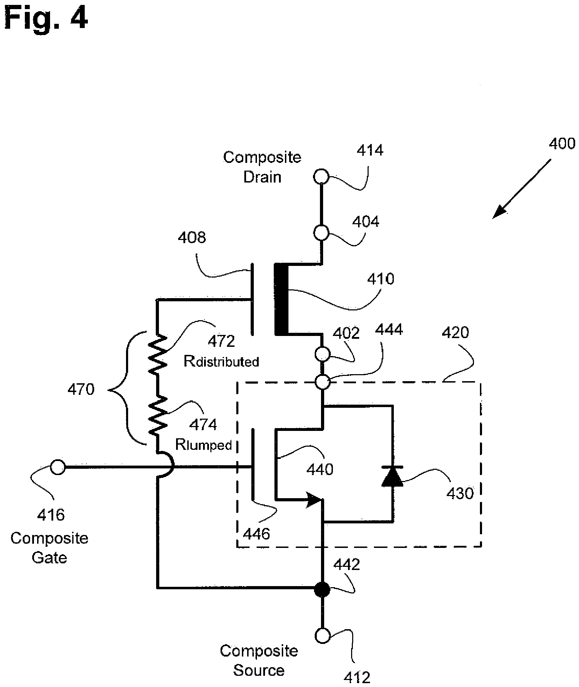

Moving to Figure 4, Figure 4 shows one exemplary implementation of a composite semiconductor device. As noted above, in power management applications where normally OFF characteristics of power devices are desirable, a depletion mode (e.g., normally ON) III-Nitride power transistor can be cascoded with a low voltage (LV) semiconductor device to produce an enhancement mode (e.g., normally OFF) composite power device. However, and as further noted above, when implemented in combination with an LV semiconductor device to form a composite device used in high current applications, the gate of a III-Nitride power transistor may tend to oscillate in series with semiconductor package inductances and the output capacitance of the LV semiconductor device, for example, causing the III-Nitride power transistor to be turned OFF and ON, possibly destructively. In order to render such a composite device suitable for operation in power management systems, where high slew rate conditions may be encountered, the composite device should be configured to be oscillation resistant.

One such configuration is shown in Figure 4. As shown in Figure 4, composite semiconductor device 400 includes III-Nitride power transistor 410 having source 402, drain 404 and gate 408, and LV device 420 cascoded with III-Nitride power transistor 410. As further shown in Figure 4, LV device 420 includes LV transistor 440 including source 442, drain 444 and gate 446, as well as LV diode 430. Also shown in Figure 4 are composite source 412, composite drain 414 and composite gate 416 of composite semiconductor device 400. **III**-Nitride power transistor 410 corresponds to III-nitride transistors 200 and 300, shown in respective Figures 2 and 3, and may include any of the features previously attributed to those corresponding devices, above.

LV device 420 is shown to include LV transistor 440 and LV diode 430. In one implementation, LV diode 430 may simply be a body diode of LV transistor 440, while in another implementation, LV diode 430 may be a discrete diode coupled to LV transistor 440 as shown in Figure 4 to produce LV device 420. LV device 420 may be implemented as an LV group IV device, such as an LV silicon device having a breakdown voltage of approximately 25V, for example. According to one implementation, LV device 420 may be an LV FET, such as an LV silicon MISFET or MOSFET, for example, including LV body diode 430.

The cascoded combination of III-Nitride power transistor 410 and LV device 420 produces composite semiconductor device 400, which according to the implementation shown in Figure 4 results in a composite three terminal device functioning in effect as a FET having composite source 412 and composite gate 416 provided by LV device 420, and composite drain 414 provided by III-Nitride power transistor 410. That is to say, drain 444 of LV transistor 440 is coupled to source 402 of III-Nitride power transistor 410, source 442 of LV transistor 440 provides composite source 412 for composite semiconductor device 400, and gate 446 of LV transistor 440 provides composite gate 416 for composite semiconductor device 400. In addition, drain 404 of III-Nitride power transistor 410 provides composite drain 414 for composite semiconductor device 400, while gate 408 of III-Nitride power transistor 410 is coupled to source 442 of LV transistor 440. Furthermore, and as also shown by Figure 4, gate 408 of III-Nitride power transistor 410 is coupled to source 442 of LV transistor 440 through damping resistor 470.

Composite semiconductor device 400 can be implemented as an HV composite device configured to have passive oscillation control. As shown in Figure 4, composite semiconductor device 400 also includes damping resistor 470. In high current applications, an additional external lumped resistor my be implemented as lumped resistor 474 in order to increase damping resistor 470 and further enhance passive oscillation control so as to enable stable high slew rate operation. As such, composite semiconductor device 400 includes damping resistor 470, which is represented as lumped resistor 474 and distributed resistor 472. According to the implementation shown in Figure 4, damping resistor 470 is shown to be the sum of distributed resistor 472 and lumped resistor 474.

Similarly to the construction of III-nitride transistor 300 discussed above, lumped resistor 474 of composite semiconductor device 400 may be monolithically integrated with III-Nitride power transistor 410. In one implementation, lumped resistor 474 may be monolithically integrated within III-nitride transistor 410. It may be advantageous for lumped resistor 474 to be formed as a separate metal layer using a metal having higher resistance (e.g., AlTi) which is electrically connected in series with gate 408 of III-Nitride power transistor 410, distributed resistor 472, and composite source 412 metal layers (metal layers of III-Nitride power transistor 410 not shown in Figure 4).

As noted above, distributed resistor 472 of damping resistor 470 may be a product of the device layout. Moreover, the thickness and type of gate metal(s) utilized in III-Nitride power transistor 410 can be optimized in order to achieve a desired value for distributed resistor 472.

In certain other composite semiconductor device implementations, it may not be desirable to increase damping resistor 470 by employing distributed resistor 472 having an increased resistance, in combination with lumped resistor 474. For example, in highly efficient power management systems where it is typically desirable for a composite semiconductor device corresponding to composite semiconductor device 400 to exhibit relatively lower levels of Rdson, (e.g., Rdson less than approximately 0.25 ohms), any additional or unnecessary distributed resistance which may tend to increase the on-resistance of the composite device may be undesirable. In fact, in some implementations it may be advantageous to design composite semiconductor device 400 such that it exhibits an Rdson as low as possible. Consequently, it may be desirable to configure composite semiconductor device 400 such that III-Nitride power transistor 410 is formed with lumped resistor 474 on gate 408 to provide for damping resistance to prevent oscillations, but design the electrode at composite source 402 such that the Rdson of composite semiconductor device 400 is minimized. Figure 5 illustrates an exemplary implementation of such a configuration.

As shown in Figure 5, composite semiconductor device 500 corresponds in general to composite semiconductor device 400, in Figure 4, and may include any of the features previously attributed to that corresponding composite device, above. However, as shown in Figure 5, according to the present implementation, distributed resistor 572 is associated with metallization at composite source 512, which is coupled to both the source of LV device 520 and gate 508 of III-Nitride power transistor 510 through the damping resistance provided by lumped resistor 574. In this implementation, distributed resistor 572 may be designed such that composite semiconductor device 500 exhibits a low Rdson through the use of thicker metal lines or through the use of lower resistance materials such as Al and/or Cu, for example. Lumped resistor 574 may be a coupled discrete resistor in the circuit layout or may be monolithically integrated with III-Nitride power transistor 410, as described by reference to Figure 4.

Referring now to Figure 6, yet another exemplary implementation of a composite semiconductor device is shown. Composite semiconductor device 600 includes III-Nitride power transistor 610 and LV device 620 cascoded with III-Nitride power transistor 610. III-Nitride power transistor 610 is shown to include source 602, drain 604, and gate 608. III-Nitride power transistor 610 corresponds to III-Nitride power transistor 410/510, in Figure 4/5, and may share any of the features previously attributed to III-Nitride power transistor 410/510, above. Also shown in Figure 6 are composite anode 603 and composite cathode 605 of composite semiconductor device 600.

According to the implementation shown by Figure 6, LV device 620 is an LV diode including anode 623 and cathode 625, and may be implemented as an LV group IV diode such as an LV silicon diode, for example. LV device 620 is cascoded with III-Nitride power transistor 610 to produce composite semiconductor device 600. That is to say, cathode 625 of LV device 620 is coupled to source 602 of III-Nitride power transistor 610, anode 623 of LV device 620 provides composite anode 603 for composite semiconductor device 600, drain 604 of III-Nitride power transistor 610 provides composite cathode 605 for composite semiconductor device 600, and gate 608 of III-Nitride power transistor 610 is coupled to anode 623 of LV device 620.

The cascoded combination of III-Nitride power transistor 610 and LV device 620 produces composite semiconductor device 600, which according to the implementation shown in Figure 6 results in a composite two terminal device functioning in effect as a diode having composite anode 603 provided by LV device 620, and composite cathode 605 provided by III-Nitride power transistor 610. Moreover, composite semiconductor device 600 can be implemented as an HV composite device configured to have passive oscillation control resulting from the addition of lumped resistor 674.

Similar to the implementation shown in Figure 5, according to the implementation of Figure 6, distributed resistor 672 may be designed such that composite semiconductor device 600 exhibits a low Rdson through the use of thicker metal lines or through the use of lower resistance materials such as Al and/or Cu, for example. Lumped resistor 674 may be a coupled discrete resistor in the circuit layout or may be monolithically integrated with III-Nitride power transistor 610, as described above by reference to Figure 4.

Thus, the III-Nitride devices and composite semiconductor devices disclosed herein are configured to have passive oscillation control. As a result, a III-Nitride power transistor and/or composite device can be designed to provide a rugged device operation displaying high durability and stable performance in high current applications.

From the above description it is manifest that various techniques can be used for implementing the concepts described in the present application without departing from the scope of those concepts. Moreover, while the concepts have been described with specific reference to certain implementations, a person of ordinary skill in the art would recognize that changes can be made in form and detail without departing from the spirit and the scope of those concepts. As such, the described implementations are to be considered in all respects as illustrative and not restrictive. It should also be understood that the present application is not limited to the particular implementations described herein, but many rearrangements, modifications, and substitutions are possible without departing from the scope of the present disclosure.

## Claims

1. A III-nitride transistor including a passive oscillation control, said III-nitride transistor comprising:
a source electrode, a gate electrode and a drain electrode;
a damping resistor configured to provide said passive oscillation control for said III-nitride transistor;
wherein said damping resistor comprises at least one lumped resistor.

2. The III-nitride transistor of claim 1, wherein said III-nitride transistor includes one of a III-Nitride field-effect transistor (III-N FET) and a III-Nitride high electron mobility transistor (III-N HEMT).

3. The III-nitride transistor of claim 1, wherein said damping resistor includes said lumped resistor and a distributed resistor.

4. The III-nitride transistor of claim 3, wherein said lumped resistor comprises a higher resistance metallic material and said distributed resistor comprises a lower resistance metallic material.

5. The III-nitride transistor of claim 1, wherein said lumped resistor is monolithically integrated with said III-nitride transistor.

6. The III-nitride transistor of claim 1, wherein said lumped resistor is monolithically integrated into a metal layer of said III-nitride transistor other than a metallization layer used to form a gate of said III-nitride transistor.

7. The III-nitride transistor of claim 1, wherein said lumped resistor comprises a III-Nitride material.

8. The III-nitride transistor of claim 1, wherein said lumped resistor is monolithically integrated within a substrate of said III-nitride transistor.

9. The III-nitride transistor of claim 1, wherein said III-nitride transistor is integrated with at least one other semiconductor device to form a composite semiconductor device.

10. The III-nitride transistor of claim 9, wherein said composite semiconductor device is a normally OFF composite semiconductor device.

11. The III-nitride transistor of claim 10, wherein said normally OFF composite semiconductor device exhibits an Rdson of less than approximately 0.25 ohms.

12. A composite semiconductor device including a passive oscillation control, said composite semiconductor device comprising:
a III-Nitride power transistor;
a low voltage (LV) transistor;
a drain of said LV transistor coupled to a source said III-Nitride power transistor, a source of said LV transistor providing a composite source for said composite semiconductor device, and a gate of said LV transistor providing a composite gate for said composite semiconductor device, a drain of said III-Nitride power transistor providing a composite drain for said composite semiconductor device, a gate of said III-Nitride power transistor being coupled to said source of said LV transistor through a damping resistor;
said damping resistor configured to provide said passive oscillation control for said normally composite semiconductor device.

13. The composite semiconductor device of claim 12, wherein said III-Nitride power transistor is one of a III-Nitride field-effect transistor (III-N FET) and a III-Nitride high electron mobility transistor (III-N HEMT).

14. The composite semiconductor device of claim 12, wherein said III-Nitride power transistor and said LV transistor are monolithically integrated.

15. A composite semiconductor device including a passive oscillation control, said composite semiconductor device comprising:
a III-Nitride power transistor;
a low voltage (LV) diode;
a cathode of said LV diode coupled to a source said III-Nitride power transistor, an anode of said LV diode providing a composite anode for said composite semiconductor device, a drain of said III-Nitride power transistor providing a composite cathode for said composite semiconductor device, and a gate of said III-Nitride power transistor being coupled to said anode of said LV diode through a damping resistor;
said damping resistor configured to provide said passive oscillation control for said normally composite semiconductor device.
